# EUROPEAN PATENT APPLICATION

(11) **EP 2 777 826 A2**
(43) Date of publication of application: **17.09.2014**
(21) Application number: 14159544.7
(22) Date of filing: 13.03.2014
(51) Int. Cl.: B05C 5/02, B05C 11/10, H01L 23/00, H05K 3/34

(54) **Liquid dispensing syringe**

(30) Priority: 15.03.2013 US 201361794551 P; 30.04.2013 US 201313873871
(71) Applicant: Nordson Corporation, Westlake, OH 44145 (US)
(72) Inventor: Conner, Scott, Foxboro, MA Massachusetts 02035 (US); Ali, Mohammad, Holland, PA Pennsylvania 18966 (US)
(74) Representative: Findlay, Alice Rosemary

(57) **Abstract**

A syringe for dispensing liquid materials to a substrate. In one embodiment, the syringe includes a barrel having a first end, a second end, and an interior reservoir. A piston is slidably disposed within the reservoir and is movable to increase or decrease a volume of the interior reservoir near the first end of the barrel. At least a portion of at least one of the barrel, the piston, or the dispensing tip comprises a material selected to maintain operative structural integrity of the dispensing syringe at elevated temperatures.

## Description

This invention relates generally to the field of dispensing liquid materials, and more particularly to a syringe for dispensing liquid materials.

Various types of dispensers are used in many industries for placing liquids, such as adhesives, conformal coating materials, solder paste, solder flux, and other similar materials, onto substrates during an assembly process. One type of liquid dispenser is a syringe-type dispenser having a dispenser body defining a barrel reservoir for holding a supply of liquid material to be dispensed. A dispensing tip is coupled to the syringe at one end, and is in fluid communication with the reservoir. A piston disposed in the reservoir is movable therein to pressurize the liquid in the reservoir and thereby dispense a small amount of liquid from the dispensing tip and onto a substrate.

Many industrial applications require that the liquid be dispensed in very precise volumes and at precise locations. To this end, liquid dispensers include actuators for moving the piston within the reservoir in a controllable and predictable manner. For instance, pneumatic actuators are known in the art and use compressed air applied to the piston to move the piston and dispense liquid from the dispenser. Those skilled in the art will recognize that other types of actuators, such as linear actuators, may be used to control movement of the piston within the reservoir. In other applications where precise dispensing is not required, the piston may be moved through manual processes.

In some applications, the liquid to be dispensed must be heated to about 150 degrees Celsius, or even higher. For example, dispensing hot melt type adhesives, such as polyurethane adhesives (PUR), typically require heating the adhesive to about 150 degrees Celsius, or higher, and maintaining the adhesive at that temperature until it is dispensed to a desired substrate. When syringe-type dispensers used to dispense such liquids comprise polymeric materials, the elevated temperatures may affect the integrity or performance of the syringe components and limit the effectiveness of the dispenser. A need exists for a syringe-type dispenser that overcomes these and other drawbacks of conventional syringe-type dispensers.

According to one aspect, a dispensing syringe includes a barrel having first and second ends, and an interior reservoir. A piston may be slidably disposed within the reservoir and is movable within the reservoir between first and second positions to increase or decrease a volume at the first end of the barrel. The dispensing syringe may further include a dispensing tip proximate the first end of the barrel. The dispensing tip includes an outlet in fluid communication with said reservoir for dispensing liquid material to a substrate. At least a portion of at least one of the barrel, the piston, or the dispensing tip comprises a material selected to maintain operative structural integrity of the dispensing syringe at temperatures above about 150 degrees Celsius.

The piston may have first and second ends, and the first end may have a generally hemispherical shaped surface profile with an elongated apex extending along a central axis of the piston. The surface profile facilitates dispensing fluid from the first end of the barrel when the piston is moved in a direction toward the first end. The dispensing syringe reduces or eliminates air entrapment and minimizes the volume of material left in the syringe after the piston has been fully engaged with the first end of the barrel.

The piston may also include a circumferentially-extending wiper seal located between the first and second ends of the piston. The piston may further include one or more fluid passages defined on the hemispherically-shaped surface. The fluid passages extend between the first and second ends of the piston and help to reduce the accumulation of air beneath the first wiper when the interior reservoir is filled from the first end of the barrel. The piston may be configured to permit gas to pass from the first volume, while retaining liquid within the first volume. In one embodiment, at least a portion of the piston is textured to facilitate passing gas from the first volume, while retaining the liquid.

The syringe barrel may include a radially inwardly extending ledge within the interior reservoir. The ledge engages the wiper seal when the piston is moved toward the first end of the barrel to engage the piston with the first end. Engagement between the wiper seal and the ledge squeezes liquid material from beneath the wiper, thereby minimizing liquid material remaining in the reservoir when the piston is moved to the first end of the barrel.

An adapter may be used for coupling the dispensing syringe to a source of pressurized air. The adapter may include a first end for coupling to a syringe barrel and a second end for coupling to the source of pressurized air. First and second hubs on the first end of the adapter engage ears on the barrel to secure the adapter to the barrel. The ears of the barrel may have radial extents that are small compared to the circumferential lengths of the ears, so that deflection of the ears is reduced or eliminated during use of the dispensing syringe. The adapter may further include a seal extending from the first end of the adapter for engaging the open end of the barrel when the first and second hubs engage the ears on the barrel.

An end cap may be used with the syringe barrel when the adapter is not used to couple the syringe barrel to a source of pressurized air.

A tip cap may be secured to a male luer connector at the first end of the syringe barrel. The tip cap could include an end wall with a skirt and an annular boot extending axially outward from the end wall. The boot is positioned concentrically within the skirt to define a space for frictionally gripping the male luer connector therein.

In another aspect, at least a portion of at least one of the components of the syringe may comprise a material selected to maintain the structural integrity of the syringe at elevated temperatures. For example, one or more of the syringe barrel, piston, or luer coupling may comprise a material that is capable of maintaining the structural integrity of the syringe at elevated temperatures. Moreover, one or more of a tip cap, end cap, or adapter for coupling the syringe barrel to a source of pressurized air may comprise a material that is capable of maintaining the structural integrity of the syringe at elevated temperatures.

The invention will now be further described by way of example with reference to the accompanying drawings, in which:
FIG. 1 is a perspective view of an exemplary dispensing syringe.
FIG. 2 is an exploded perspective view of the dispensing syringe of FIG. 1.
FIG. 3 is a side elevation view of the barrel of the dispensing syringe of FIG. 1.
FIG. 3A is an enlarged cross-sectional view of the syringe barrel of FIG. 3, taken along line 3A-3A.
FIG. 3B is an enlarged cross-sectional view of an alternative embodiment of the syringe barrel of FIG. 3.
FIG. 4 is a perspective view of an exemplary end cap for use with the syringe barrel of FIG. 3.
FIG. 4A is a cross-sectional view of the end cap of FIG. 4, taken along line 4A-4A.
FIG. 5 is a perspective view of an exemplary tip cap for use with the syringe barrel of FIG. 3.
FIG. 5A is a cross-sectional view illustrating the tip cap of FIG. 5 on the syringe barrel of FIG. 3.
FIG. 6 is a side elevation view of an exemplary adapter, as shown in FIGS. 1-2, for use with the syringe barrel of FIG. 3.
FIG. 6A is a cross-sectional view of the adapter of FIG. 6, taken along line 6A-6A.
FIG. 7 is a cross-sectional view illustrating the piston of the syringe of FIG. 1 at the first end of the syringe barrel.

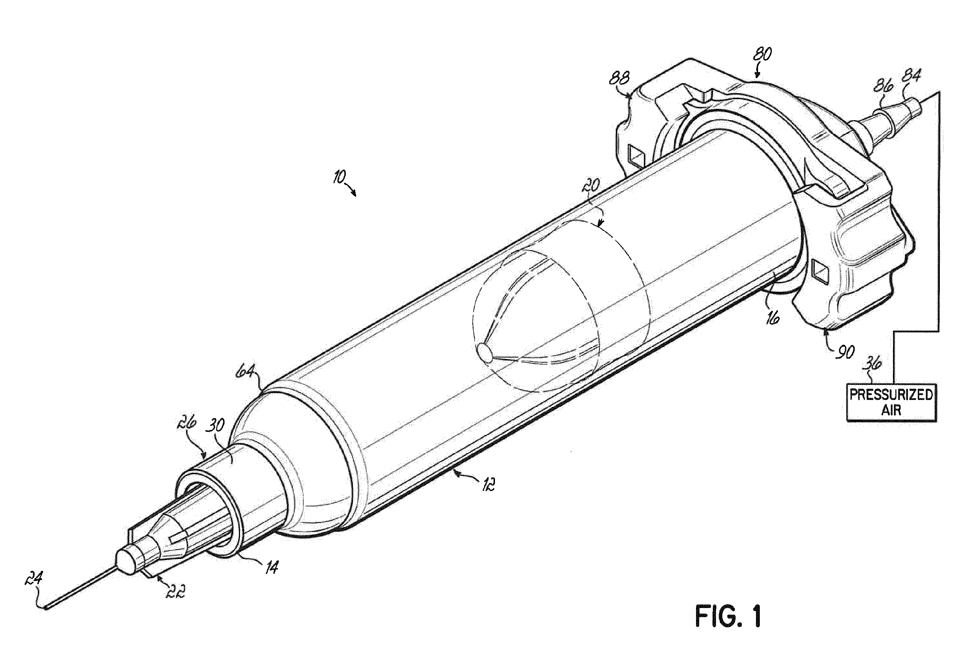

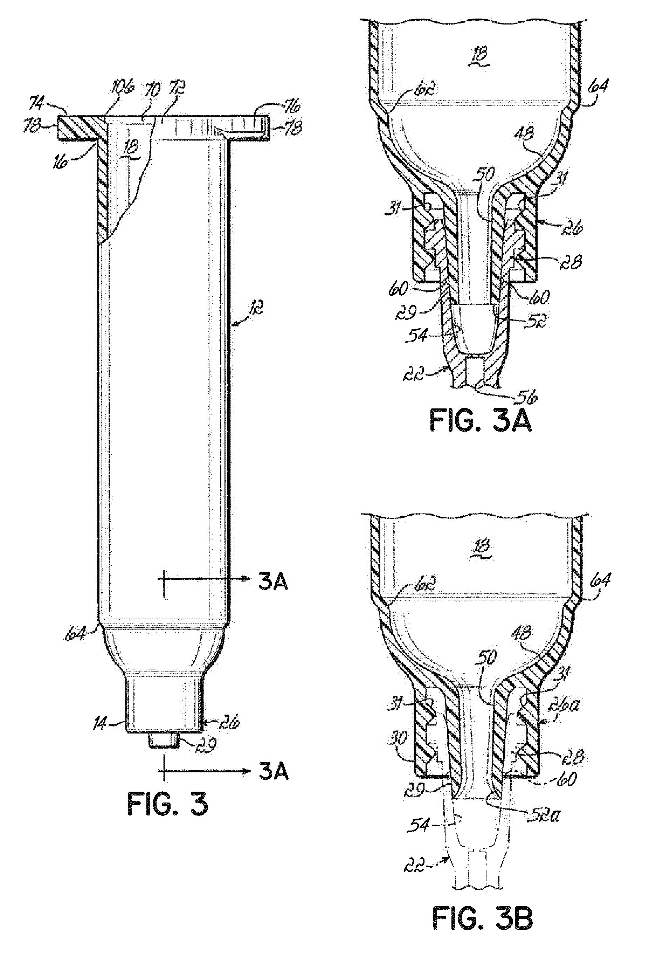

FIGS. 1, 2, 3, 3A, and 3B illustrate an exemplary liquid dispensing syringe 10. The syringe 10 comprises a generally elongate syringe barrel 12 having a first end 14 for dispensing liquid material therefrom, and a second end 16 opposite the first end 14. The barrel 12 defines an interior reservoir 18 (FIG. 3) for containing the liquid material to be dispensed from the first end 14. A piston 20 is slidably disposed within the interior reservoir 18 and is slidably movable therein between the first and second ends 14, 16 to thereby dispense liquid material from the first end 14 as the piston 20 moves in a direction toward the first end 14. A dispensing tip 22 is removably coupled to the first end 14 of the barrel 12 for communication with the interior reservoir 18 such that liquid material may be dispensed from an outlet 24 of the dispensing tip 22.

In the embodiment shown, the first end 14 of the barrel 12 includes a male luer connector 26 adapted to receive a corresponding female luer 28 provided on the dispensing tip 22, whereby the dispensing tip 22 may be coupled to the first end 14 of the barrel 12, as depicted in FIGS. 3, 3A, and 3B. Male luer connector 26 includes a male connecting tip 29 and a collar 30 with internal threads 31 for securing the dispensing tip 22 thereto. The second end 16 of the barrel 12 includes a comparatively large diameter opening 70 and has radially outwardly extending flanges or "ears" 74, 76 for securing an end cap 110 or an adapter 80 that facilitates coupling the second end 16 of the barrel 12 to an actuator such as a source of pressurized air 36 (FIG. 1).

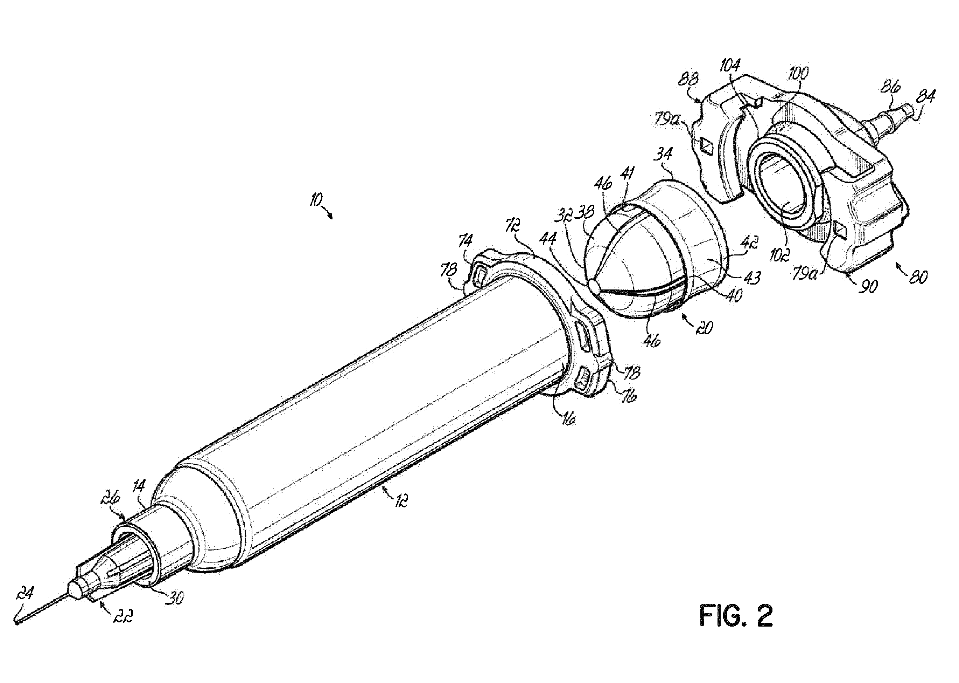

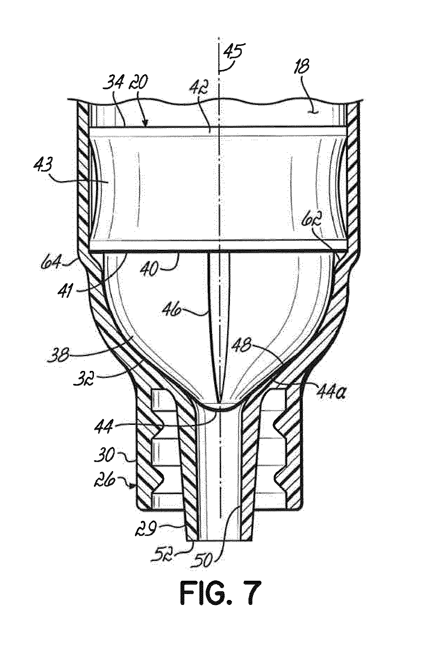

While many different pistons could be used, an example of one piston 20 is shown with reference to FIGS. 2 and 7, an exemplary piston 20 is shown. The piston 20 includes a first end 32 configured to force liquid material through the first end 14 of the barrel 12 and into the dispensing tip 22. The first end 32 of the piston 20 mates with the first end 14 of the barrel 12 to force liquid material into the dispensing tip 22. The second, opposite end 34 of the piston 20 is exposed to an actuator, such as the source of pressurized air 36 (FIG. 1), whereby the piston 20 may be actuated in a direction from the second end 16 of the barrel 12 toward the first end 14 of the barrel 12. At least one first circumferential wiper 40 extends radially outwardly from a hemispherically-shaped surface 38 of the piston 20 to sealingly engage the interior walls of the barrel 12. The wiper 40 may be in the form of a flange or skirt extending circumferentially around the body of the piston 20 and forms a step 41 relative to the hemispherically-shaped surface 38. The step 41 is believed to be important to providing a minimum dead volume within the interior reservoir 18. A second wiper 42 may be provided near the second end 34 of the piston 20, and may be formed generally the same as the first wiper 40 to sealingly engage the interior surface of the barrel 12.

The surface of the piston 20, at least proximate the first and second wipers 40, 42, and optionally in the region 43 between the first and second wipers 40, 42, may be configured to facilitate micro-venting of gaseous material, such as air that may be trapped within the interior reservoir 18, while preventing liquid material from escaping the interior reservoir 18. For example, the first wiper 40, the second wiper 42, and/or the region 43 may be textured in such a way that gaseous material may pass from the interior reservoir 18, but liquid material is retained in the interior reservoir 18. Alternatively, some or all of the piston 20 may be formed from material that is permeable to gases, but impermeable to liquids to facilitate passing gaseous materials from the internal reservoir 18. It will be appreciated that various other methods may be used to facilitate passing gaseous material from the internal reservoir 18, while preventing liquid material from escaping. The region 43 may also have a concave profile to minimize material shear and pressure, and to minimize entrapping gas between the first and second wipers 42, 43.

With continued reference to FIGS. 2 and 7, the first end 32 of the piston 20 has a smooth radial profile defining a generally hemispherically-shaped surface 38 that more evenly distributes pressure throughout the liquid material as the piston 20 is moved toward the first end 14 of the barrel 12 to dispense liquid material from the tip 22, and minimizes shear in the liquid material. In the embodiment shown, an apex 44 of the piston 20 forms a tip at the first end 32 of the piston 20. The apex 44 can be elongated along a central axis 45 of the piston 20 such that the apex 44 extends outwardly from the hemispherical surface 38 and can thereby extend downwardly into a portion of the male luer 26 when the piston 20 is engaged with the second end 14 of the barrel 12. The elongated apex 44 includes a curved region 44a that provides a smooth transition from the hemispherically-shaped surface 38 and forms a bullet-nose shape, for example. This elongated apex 44 of the piston 20 helps to dispense liquid material through the dispensing tip 22 and minimizes waste retained within the dispenser 10.

The piston 20 may further include flow passages 46 defined on the hemispherically-shaped surface 38 of the piston 20, between the apex 44 and the first wiper 40. The flow passages 46 may be defined by channels formed into the outer surface 38 of the piston 20, or they may be defined by outwardly extending ribs or surfaces (not shown) disposed on the first end 32 of the piston 20. In the embodiment shown, the flow passages 46 are channels formed into the first end 32 of the piston 20 and are approximately .003 to 005 inch deep.

When the barrel reservoir 18 is filled from the first end 14 of the barrel 12, liquid material is directed along the flow passages 46 from the apex 44 of the piston 20 toward the first wiper 40. The movement of liquid material along flow passages 46 forces entrapped air toward the first wiper 40 where the air may pass through. The wiper 40, however, prevents the liquid material from material from passing. In this way, the accumulation of air beneath the first wiper 40 is reduced or eliminated.

In the embodiments illustrated in FIGS. 3A-3B, the first end 14 of the syringe barrel 12 and a dispensing tip 22 are shown in more detail. The barrel 12 cooperates with the design of the dispensing tip 22 to minimize the shear of liquid material and to reduce or eliminate the formation of air pockets within the barrel reservoir 18 during filling and/or dispensing operations. To this end, the first end 14 of the barrel 12 includes a smoothly curved profile 48 corresponding to the hemispherically-shaped surface 38 of the first end 32 of the piston 20. In one embodiment, the curved profile 48 may include a radius in the range of about 5/32-inch to about 3/16-inch, or greater. The curved profile 48 helps to direct liquid material through an outlet passageway 50 and outlet orifice 52 at the first end 14 of the barrel 12 to provide smooth transition into the inlet 54 of the dispensing tip 22. The inner diameter of the outlet passageway 50 may be tapered to minimize shear in the liquid material as it is dispensed from the barrel 12 into the dispensing tip 22. In the embodiment depicted in FIG. 3A, the outlet orifice 52 of the syringe barrel 12 has a relatively blunt shape. Alternatively, the outlet orifice 52a of the barrel 12 may be flared gradually outwardly toward the interior of the dispensing tip inlet 54 to provide a smooth transition between the first end 14 of the barrel 12 and the dispensing tip 22, as depicted in FIG. 3B. The interior of the dispensing tip inlet 54 may have generally frustoconically-shaped sidewalls or "bullet-nose"-shaped sidewalls to minimize entrapment of air within the dispensing tip 22, and to provide a generally smooth transition between the inlet 54 of the dispensing tip 22 and the outlet passageway 56.

With continued reference to FIG. 3A, the outlet passageway 50 of the syringe barrel 12 extends over a circumferential groove 60 formed in the inlet 54 of the dispensing tip 22. This groove 60, or "stripper ring" is formed into the dispensing tip 22 during a molding process and helps to retain the dispensing tip 22 on one half of a removable core member as the other half of the core is removed from the molded tip 22. The tip 22 is subsequently ejected from the core member and the stripper ring 60 remains within the inlet passageway of the dispensing tip 22.

The first end 14 of the syringe barrel 12 further includes an interior ledge 62 adapted to engage the first wiper 40 on the piston 22 as the piston 22 engages the interior surface at the first end 14 of the barrel 12. As the interior ledge 62 engages the first wiper 40, liquid material beneath the wiper 40 is further forced from the wiper 40, thereby reducing liquid material waste. In the embodiment shown, the barrel 12 is provided with a uniform wall thickness such that the interior ledge 62 creates a corresponding radially outwardly extending ledge 64 on the exterior surface of the barrel 12, giving a distinctive visual appearance to the first end 14 of the syringe barrel 12.

With continued reference to FIGS. 2 and 3, the second end 16 of the syringe barrel 12 includes a relatively large diameter opening 70 and has a radially outwardly extending flange 72. A pair oppositely disposed tabs or ears 74, 76 extend radially outwardly from the flange 72, in opposite directions, to facilitate securing an end cap 110 or an adapter 80 for coupling the syringe 10 to an actuator, as will be described in more detail below. The radially extending length of the ears 74, 76 is generally smaller than conventional syringe ears to minimize flexure of the ears 74, 76 during use. This flexure can cause variations in dispensed volumes of liquid material when a pressure pulse is applied to the syringe 10 to cause the piston 20 to move in a direction toward the first end 14 of the barrel 12. Repeated flexure of the ears 74, 76 over time can fatigue the material of the barrel 12, thereby further increasing deflection of the ears 74, 76 and the variation in dispensed volumes of liquid material. Advantageously, the reduced lengths of the ears 74, 76 in the syringe 10 of the embodiment shown reduces the flexure of the ears 74, 76 thereby improving the consistency of the volumes of liquid material dispensed from the syringe 10. In the embodiment shown, each ear 74, 76 further includes a radially outwardly extending detent or bump 78, formed on an outer periphery thereof, to provide positive engagement with an end cap 110 or an adapter 80 which may be coupled to the second end 16 of the barrel 12, as described in more detail below.

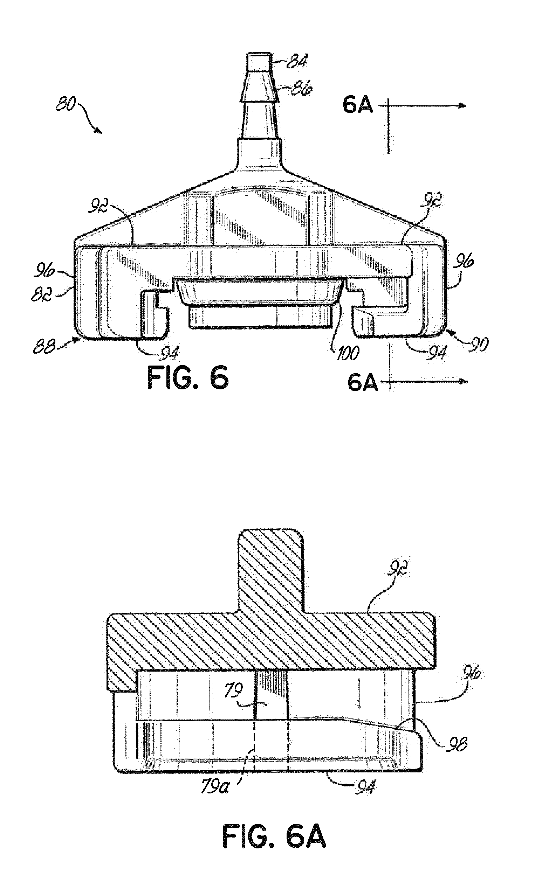

FIGS. 6 and 6A illustrate an exemplary adapter 80 configured to be coupled to the second end 16 of the syringe barrel 12 to facilitate coupling the syringe 10 to an actuator, such as a source of pressurized air 36. In the embodiment shown, the adapter 80 includes a first end 82 adapted to be coupled to the second end 16 of the barrel 12, and a second end 84 adapted to be coupled to a conduit (not shown) which communicates with a source of pressurized air 36. The second end 84 of the adapter may include a barb 86 to facilitate securing the conduit thereto. The first end 82 of the adapter 80 includes first and second oppositely disposed hubs 88, 90 for engaging the first and second ears 74, 76 at the second end 16 of the barrel 12, in a bayonet-type fashion. Each hub 88, 90 is defined by a radially extending rim 92, an end wall 94 spaced from the rim 92, and a circumferentially extending sidewall 96 extending therebetween. The end wall 94 has an interior surface 98 (FIG. 6A) that is sloped in a direction toward the rim 92 to draw the adapter 80 tightly against the second end 16 of the barrel 12 as the adapter 80 is twisted to receive the ears 74, 76 within the respective hubs 88, 90 of the adapter.

With continued reference to FIGS. 6 and 6A, and referring to FIG. 2, the first end 82 of the adapter 80 further includes a seal 100 disposed on a centrally located cylindrical boss 102 that protrudes from the end wall 94 in a direction opposite the second end 84. A radially outwardly extending flange 104 retains the seal 100 on the cylindrical boss 102. In the embodiment shown, seal 100 is an O-ring, but it will be appreciated that various other types of sealing devices may alternatively be used. When mounted to the syringe barrel 12, the seal extends axially within the second end 16 of the syringe barrel 12 to engage an interior surface of the syringe barrel 12. To fully engage the seal 100 with the interior surface of the syringe barrel 12, the adapter 80 must be rotated to receive the ears 74, 76 of the syringe barrel 12 within the hubs 88, 90 of the adapter 80. As the ears 74, 76 are received within the hubs 88, 90 of the adapter 80, the sloped surface 98 of the end wall 94 draws the seal 100 into the second end 16 of the barrel 12 and the seal 100 sealingly engages the interior surface of the syringe barrel 12.

Prior to twisting the adapter 80 to receive the ears 74, 76 within the hubs 88, 90 of the adapter 80, air can escape from the interior of the reservoir 18 past the seal 100. When the ears 74, 76 are positioned fully within the hubs 88, 90 of the adapter 80, the detents 78 formed on the ears 74, 76 engage corresponding slots 79 (FIG. 6A) formed into the side walls 96 of the adapter 80 to provide a snap fit of the adapter 80 to the ears 74, 76 of the barrel 12, thereby providing a positive indication that the adapter 80 is fully locked onto the second end 16 of the barrel 12. In the embodiment shown, the slots 79 are formed by apertures 79a formed through the end walls 94 and extending into the sidewalls 96.

The seal 100 engages a chamfer 106 (FIG. 3) formed on the second end 16 of the syringe barrel and adjacent the opening 70. Location of the chamfer 106 at the opening 70 ensures that seal 100 will not extend too far into the syringe barrel 12 and thereby provides an indication of whether the adapter 80 is properly seated and locked onto the syringe barrel 12. When the adapter 80 is not properly seated and locked, the adapter 80 will easily slip off of the second end 16 of the syringe barrel 12 due to the shallow engagement of the seal 100 with chamfer 106.

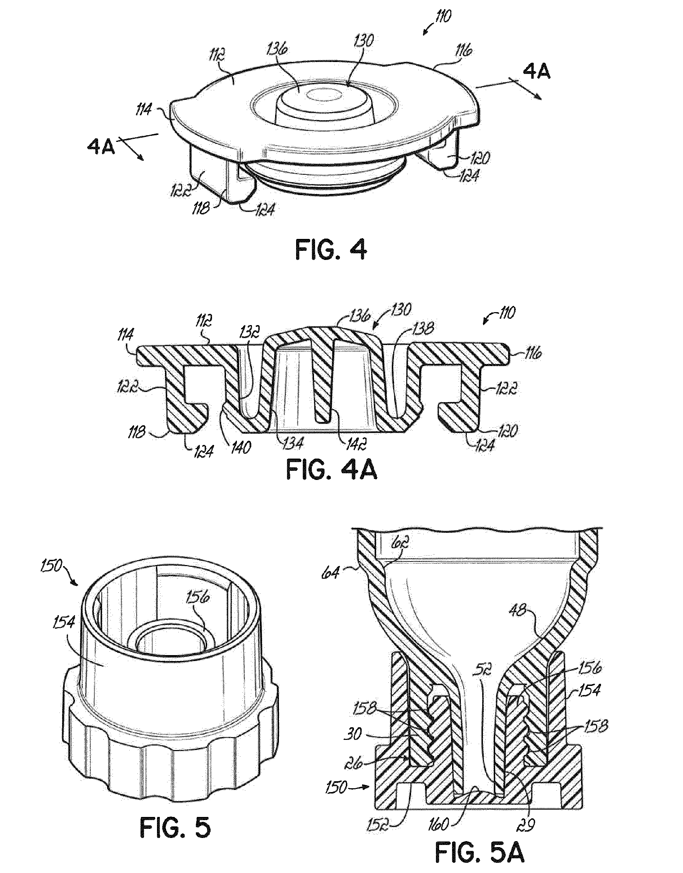

FIGS. 4 and 4A depict an end cap 110 that may be secured to the second end 16 of the syringe barrel 12, in place of adapter 80. The end cap 110 includes an annular brim 112 and first and second oppositely disposed flanges 114, 116 extending generally radially outwardly from the brim 112. First and second oppositely disposed engagement tabs 118, 120, similar to the hubs 88, 90 of the adapter 80, extend from a bottom side of the brim 112 for engaging the ears 74, 76 of the barrel 12. Each engagement tab 118, 120 comprises a sidewall 122 extending perpendicular to the brim 112, and an end wall 124 extending parallel to the brim 112. The end wall 124, brim 112, and sidewall 122 thereby define generally circumferentially extending slots adapted to receive the first and second ears 74, 76 provided on the second end 16 of the syringe barrel 12.

The end cap 110 further comprises a generally hat-shaped central portion 130 defined by first and second concentric sidewalls 132, 134 and an end wall 136. The first sidewall 132 extends axially from the brim 112 and is joined to the second sidewall 134 by an arcuate end portion 138 extending therebetween. The end wall 136 is provided on the second end of the second sidewall 134 and closes the cap. The central portion 130 of the end cap 110 permits the brim 112 to flex, thereby facilitating closure of the second end 14 of the syringe barrel 12 with the end cap 110. A generally circumferentially extending sealing bead 140 is disposed on the first sidewall 132 of the central portion 130 to provide sealing engagement of the end cap 110 with an interior surface of the syringe barrel 12. An elongate stem 142 is centrally located on the end wall 136 and extends downwardly from the end wall 136. Stem 142 facilitates the formation of the end wall 136 during manufacture. To seal the second end 14 of the barrel 12 with the end cap 110, the first tab 118 is engaged with the first ear 74 at the second end 14 of the barrel 12, and the second tab 120 is pivoted downwardly to snap over the second ear 76 while compressing the central portion 130 to cause the second tab 120 to flexibly extend over the second ear 76.

FIGS. 5 and 5A depict an exemplary tip cap 150 that may be used with the syringe 10. The tip cap 150 is configured to fit over the male luer 26 at the first end 14 of the syringe barrel 12. In the embodiment shown, the tip cap 150 includes a generally circular end wall 152, although it will be appreciated that the end wall 152 may have various other shapes. The end wall 152 may have flutes, lobes, or other features disposed around its outer periphery to facilitate gripping the tip cap 150 during installation or removal of the tip cap 150 from the syringe barrel 12. A generally cylindrical skirt 154 extends from the end wall 152 and is sized to be received over the collar 30 of the male luer 26. A generally cylindrical boot 156 also extends from the end wall 152 and is located concentrically within the skirt 154 to be received between the male connecting tip 29 and the collar 30 of the male luer 26. The skirt 154 and boot 156 are sized and dimensioned to provide a frictional fit on the male luer 26 such that the tip cap 150 is retained on the first end 14 of the syringe barrel 12. When the tip cap 150 is firmly seated on the male luer 26 of syringe barrel 12, a raised, central bead 160 disposed on an interior side of the end wall 152 sealingly engages the outlet orifice 52 at the first end 14 of the syringe barrel 12.

The tip cap may 150 further include one or more circumferentially extending ribs or ridges 158 provided on the boot 156 and sized to engage the threads of the male luer 26. The ribs 158 may be configured such that the tip cap 150 can be pressed axially onto the first end 14 of the syringe barrel 12, whereby the boot 156 deforms radially inwardly so that the ribs 158 ride over the threads 31 on the male luer 26. Alternatively, the tip cap 150 may be placed onto the first end 14 of the syringe barrel 12 by twisting the tip cap 150 to advance the tip cap 150 over the threads of the male luer 26. The tip cap 150 may be removed from the first end 14 of the syringe barrel 12 by twisting the tip cap 150.

In accordance with another aspect of the present invention, at least a portion of one or more of the components of a dispensing syringe may comprise a material selected to maintain the structural integrity of the dispensing syringe at elevated temperatures such that the dispensing syringe operates as intended at such elevated temperatures. Accordingly, the dispensing syringe may be used to dispense liquid materials, such as, but not limited to, hot melt adhesives that require heating to elevated temperatures. As a non-limiting example, a dispensing syringe in accordance with the principles of the present invention may be used to dispense polyurethane hot melt adhesive (PUR) at elevated temperatures such as up to about 150 degrees Celsius. In another embodiment, the material may be selected to maintain structural integrity at elevated temperatures up to about 200 degrees Celsius. In yet another embodiment, the material may be selected to maintain structural integrity at elevated temperatures above about 200 degrees Celsius. Because one or more of the components of the dispensing syringe, such as the barrel, the piston, or the luer coupling, are formed from a material that maintains structural integrity at elevated temperatures, these components will not soften to a degree that structural integrity of the syringe is compromised, thereby avoiding problems such as leaking or bursting under pressure.

In one embodiment, one or more of the components of the dispensing syringe 10 may comprise a resin that is resistant to elevated temperatures. For example, one or more of the components, such as the barrel 12, piston 20, dispensing tip 22, or luer connector 26 may comprise polybutylene terephthalate (PBT) or any other material suitable for maintaining the structural integrity of the components at elevated temperatures so that the intended operation of the dispensing syringe 10 is not adversely affected. Moreover, various other components of a dispensing syringe 10, such as a tip cap 150, an adapter 80, an end cap 110, or any other component of a dispensing syringe, or any component usable with a dispensing syringe, may comprise polybutylene terephthalate (PBT) or any other material suitable for maintaining the structural integrity of the components at elevated temperatures. The material may further include additives to improve characteristics or performance of the material during use. For example, the material may be a composite material including reinforcing fibers, such as, but not limited to glass fibers, to improve the strength of the material. While the material is described herein as including reinforcing fibers, it will be appreciated that a composite material formed with other reinforcing material may alternatively be used.

In another feature, one or more of the components of the dispensing syringe 10 may comprise a material that includes additives to improve resistance of the material to flames or ultraviolet radiation (UV), as may be desired. Moreover, various other components of the dispensing syringe 10, such as the adapter 80, end cap 110, or tip cap 150, may also comprise material that maintains structural integrity at elevated temperatures, including additives as discussed above, so that the intended operation of the dispensing syringe 10 is not adversely affected.
While the present invention has been illustrated by the description of various exemplary embodiments thereof, and while the embodiments have been described in considerable detail, additional advantages and modifications will readily appear to those skilled in the art. The various features discussed herein may be utilized alone or in any combination.

## Claims

1. A dispensing syringe, comprising a barrel having a first end and a second end, and defining an interior reservoir therein, a dispensing tip proximate said first end of said barrel, said dispensing tip including an outlet in fluid communication with said reservoir, wherein at least a portion of at least one of said barrel or said dispensing tip comprises a material selected to maintain operative structural integrity of the dispensing syringe at temperatures above about 150 degrees Celsius.

2. The dispensing syringe of claim 1, further comprising a piston slidably disposed within said interior reservoir.

3. The dispensing syringe of claim 2, wherein the piston comprises polybutylene terephthalate.

4. A dispensing syringe, comprising a barrel having a first end and a second end, and defining an interior reservoir therein, a piston slidably disposed within said reservoir to thereby increase or decrease a volume of said interior reservoir proximate said first end of said barrel, said piston having a first end and a second end, said first end having a generally hemispherically-shaped surface profile with an elongated apex extending along a central axis thereof for dispensing fluid from said first end of said barrel when said piston is moved toward said first end of said barrel, and a luer coupling at said first end of said barrel adapted for receiving a dispensing tip, said luer coupling including an outlet orifice and an outlet passage in fluid communication between said outlet orifice and said reservoir, said outlet passage tapered along an axial length thereof, wherein at least a portion of at least one of said barrel, said piston, or said luer coupling comprises a material selected to maintain operative structural integrity of the dispensing syringe at temperatures above about 150 degrees Celsius.

5. The dispensing syringe of claim 4, further comprising an end cap selectively removably coupled to said second end of said barrel for sealing said barrel.

6. The dispensing syringe of either claim 4 or claim 5, further comprising a tip cap selectively removably coupled to said luer coupling at said first end of said barrel and sealingly engaging said outlet orifice of said luer coupling when said tip cap is firmly seated on said luer coupling.

7. The dispensing syringe of any one of claims 4 to 6, wherein said barrel further comprises an elongate tubular body including at least one sidewall defining said interior reservoir, said sidewall further defining a hemispherically-shaped portion within said interior reservoir proximate said first end of said body and complementary to said hemispherically-shaped surface profile of said piston.

8. The dispensing syringe of claim 7, wherein said barrel further comprises a radially inwardly extending ledge within said interior reservoir adjacent said hemispherically-shaped portion, said sidewall having a substantially uniform thickness proximate said ledge, whereby the location of said radially inwardly extending ledge is visible externally of said body by a corresponding radially outwardly extending ledge.

9. The dispensing syringe of any preceding claim, wherein said material comprises a high temperature resin.

10. The dispensing syringe of claim 9, wherein said material comprises polybutylene terephthalate.

11. The dispensing syringe of either claim 9 or claim 10, wherein said material is a composite material that further comprises fiber reinforcement.

12. The dispensing syringe of any preceding claim, further comprising an adapter selectively removably coupled to said second end of said barrel for coupling said barrel to a source of pressurized fluid.

13. The dispensing syringe of any preceding claim further comprising a hot melt adhesive disposed in the interior reservoir.

14. A method of dispensing a hot melt adhesive, comprising:
heating a dispensing syringe to liquefy hot melt adhesive disposed within an interior reservoir of the dispensing syringe, the dispensing syringe comprising:
a barrel having a first end and a second end and defining the interior reservoir therein,
a dispensing tip proximate the first end of the barrel,
an outlet in fluid communication with the interior reservoir, and
a piston slidably disposed within the interior reservoir,
wherein at least a portion of at least one of the barrel or the dispensing tip comprises a material selected to maintain operative structural integrity of the
dispensing syringe at temperatures above about 150 degrees Celsius; and
moving the piston in a direction toward the dispensing tip to dispense the hot melt adhesive from the outlet.

15. The method of claim 14, wherein the dispensing syringe further comprises:
a luer coupling at the first end of the barrel and adapted for receiving the dispensing tip, the luer coupling including an outlet orifice and an outlet passage in fluid communication between the outlet orifice and the reservoir, the outlet passage tapered along an axial length thereof;
wherein the piston has a first end and a second end, the first end having a generally hemispherically-shaped surface profile with an elongated apex extending along a central axis thereof for dispensing fluid from the first end of the barrel when the piston is moved toward the first end of said barrel; and
wherein at least a portion of at least one of the barrel, the piston, or the luer coupling comprises a material selected to maintain operative structural integrity of the dispensing syringe at temperatures above about 150 degrees Celsius.
